# EUROPEAN PATENT APPLICATION

(11) **EP 2 869 462 A1**
(43) Date of publication of application: **06.05.2015**
(21) Application number: 14190536.4
(22) Date of filing: 27.10.2014
(51) Int. Cl.: H02S 40/34

(54) **Junction box and photovoltaic module including the same**

(30) Priority: 29.10.2013 KR 20130129560
(71) Applicant: Samsung SDI Co., Ltd., Yongin-si, Gyeonggi-do (KR)
(72) Inventor: Lee, Seunghee, Gyeonggi-do (KR); Lee, Jaehoon, Gyeonggi-do (KR); Lee, Jongchul, Gyeonggi-do (KR); Choi, Sundong, Gyeonggi-do (KR); Jung, Chanyoon, Gyeonggi-do (KR); Kim, Bumrae, Gyeonggi-do (KR); Choi, Yongmo, Gyeonggi-do (KR); Im, Jongsan, Gyeonggi-do (KR); Son, Jeongho, Gyeonggi-do (KR); Kang, Yoonmook, Gyeonggi-do (KR)
(74) Representative: Walaski, Jan Filip

(57) **Abstract**

A junction box connected to a photoelectric converter and including a body with a diode. The body includes first parts that are parallel to each other, a second part connecting ends of the first parts, and a bridge connecting the first parts. The diode is in the bridge, and the second part is spaced from the bridge to form an opening.

## Description

The invention relates to a photovoltaic device.

A photovoltaic cell converts light into electrical energy, and may be used to form the next generation of battery cells. Photovoltaic cells may be classified into silicon photovoltaic cells, thin film photovoltaic cells, dye-sensitized photovoltaic cells, and organic polymer photovoltaic cells according to materials thereof.

A photovoltaic module includes a plurality of photovoltaic cells connected in series or parallel. A photovoltaic module may also include a junction box to collect electricity produced by the photovoltaic cells. One type of junction box includes a diode attached to the back side of the photovoltaic module. The diode may function to block reverse currents.

While diodes may be beneficial in photovoltaic modules for some purposes, they are not without drawbacks. For example, a diode in a junction box may generate heat, which may serve to raise the temperature of the photovoltaic cells. When this occurs, the efficiency of the photovoltaic cells may be lowered.

Also, when photovoltaic cells having different output powers are connected in series, the total current of the photovoltaic cells may be adjusted by a lower current. When the photovoltaic cells are connected in parallel under the same conditions, the total voltage of the photovoltaic cells may be adjusted by a lower voltage. That is, in case of a hot spot phenomenon in which one of a plurality of connected photovoltaic cells is relatively hot, the total efficiency of a photovoltaic module may be lowered.

According to an aspect of the invention, there is provided a photovoltaic module, comprising first and second substrates, a photoelectric converter between the first and second substrates and a junction box mounted to the second substrate, the junction box including a diode electrically connected to the photoelectric converter, wherein the junction box comprises a pair of first mounting parts arranged to support the junction box on the second substrate and a bridge arranged between the first mounting parts, the diode being mounted in the bridge, wherein the lower surface of the bridge closest to the second substrate is spaced apart from the second substrate.

In accordance with one embodiment, a junction box includes a diode and a body including the diode, where the body includes first parts parallel to each other, a second part connecting ends of the first parts, and a bridge connecting the first parts, and where the diode is in the bridge and the second part is spaced from the bridge to form an opening. The bridge may include a bottom surface higher than bottom surfaces of the first parts and a bottom surface of the second part. A top surface, a pair of lateral surfaces, and the bottom surface of the bridge may be exposed to air.

The bridge may protrude outwardly more than the first parts and the second part. The first may include respective electrodes connected to the diode. The bridge may include a support on which the diode is placed, and the support is thicker than another other region of the body. The junction box may include connection parts on other ends of the first parts, respectively. The body may include an upper case and a lower case, and the upper case and the lower case may be formed in one piece.

In accordance with another embodiment, a photovoltaic module includes a first substrate facing a second substrate; a photoelectric converter between the first and second substrates; and a junction box attached to the second substrate and electrically connected to the photoelectric converter. The junction box includes a pair of first parts parallel to each other; a second part connecting ends of the first parts; and a bridge connecting the first parts and including the diode, where the second part is spaced from the bridge to form an opening.

The bridge may include a bottom surface higher than bottom surfaces of the first parts and a bottom surface of the second part. The photovoltaic module includes a gap is between the second substrate and bottom surface of the bridge. The photovoltaic module may include an adhesive layer between the second substrate and the bottom surfaces of the first parts and the bottom surface of the second part. The gap may be connected to the opening.

The bridge may protrude outwardly more than the first parts and the second part. The first parts may include respective electrodes connected to the diode. The photoelectric converter may include a plurality of photovoltaic cells; and a ribbon connecting the plurality of photovoltaic cells, where ends of the electrodes are electrically connected to the ribbon.

Connection parts may be located on other ends of respective ones of the first parts. The first parts, second part, and bridge may be formed in one piece. The bridge may include a support on which the diode is placed, and the support may be thicker than another region of the body. The photoelectric converter may include a thin-film photovoltaic cell, and the thin-film photovoltaic cell may include a back electrode layer, a light absorbing layer, a buffer layer, and a light transmitting electrode layer sequentially stacked on the second substrate.

Features will become apparent to those of skill in the art by describing in detail exemplary embodiments with reference to the attached drawings in which:
FIG. 1 illustrates an embodiment of a photovoltaic module;
FIG. 2 illustrates another view of the photovoltaic module;
FIG. 3 illustrates a view of a junction box of the photovoltaic module;
FIG. 4 illustrates a view along section line I-I in FIG. 3;
FIG. 5 illustrates a portion of the junction box;
FIG. 6 illustrates an example of a measured temperature distribution of a second substrate in FIG. 1;
FIG. 7 illustrates another embodiment of a photovoltaic module; and
FIG. 8 illustrates a view of portion A in FIG. 7.

Example embodiments are described more fully hereinafter with reference to the accompanying drawings; however, they may be embodied in different forms and should not be construed as limited to the embodiments set forth herein. Rather, these embodiments are provided so that this disclosure will be thorough and complete, and will fully convey exemplary implementations to those skilled in the art.

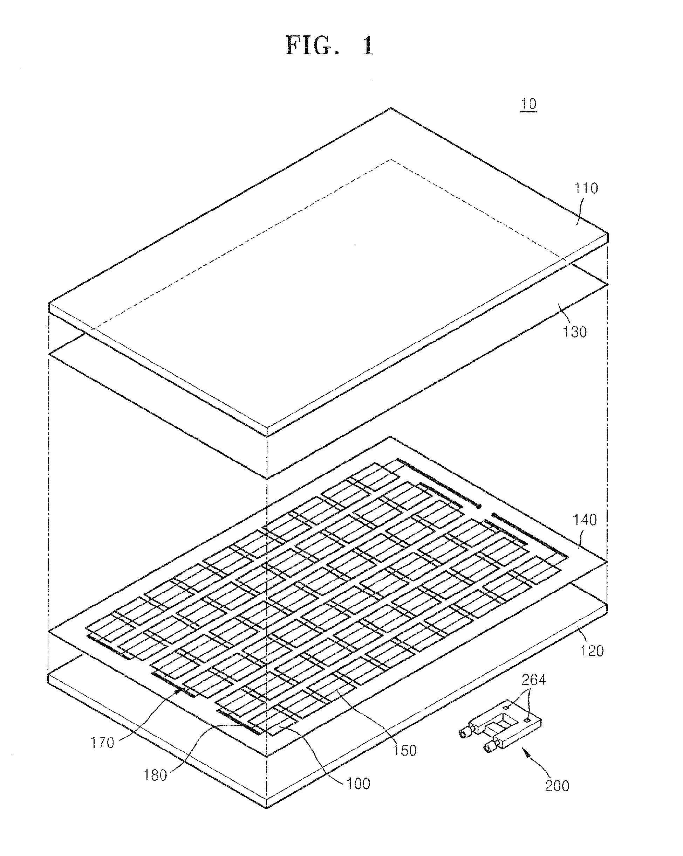

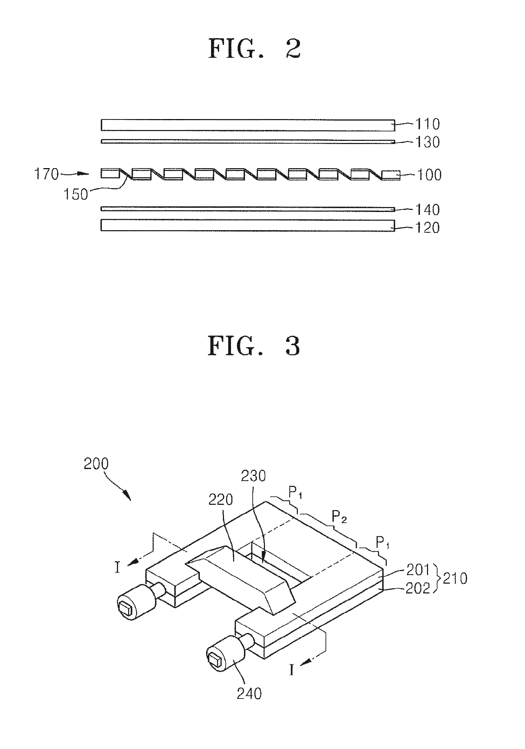

FIG. 1 illustrates an embodiment of a photovoltaic module 10, and FIG. 2 illustrates a side view of this module. Referring to FIGS. 1 and 2, photovoltaic module 10 includes first and second substrates 110 and 120 facing each other, a photoelectric converter 170 between the first and second substrates 110 and 120, and a junction box 200 attached to the second substrate 120 and electrically connected to the photoelectric converter 170.

The photoelectric converter 170 converts light (e.g., solar energy) into electrical energy. For this purpose, the photoelectric converter 170 includes a plurality of photovoltaic cells 100. Each photovoltaic cell 100 may include a silicon substrate of a first conductivity type, a semiconductor layer of a second conductivity type on the silicon substrate, and an anti-reflection film. The second conductivity type is opposite to the first conductivity type. The anti-reflection film is on and has at least one opening to expose a portion of the semiconductor layer.

Each photovoltaic cell 100 may further include a front electrode and a back electrode. The front electrode contacts the portion of the second conductivity type semiconductor layer exposed through the at least one opening. The back electrode is on a back surface of the first conductivity type silicon substrate.

In other embodiments, the photoelectric converter 170 may include a different type of photovoltaic cells. For example, photoelectric converter 170 may include thin-film photovoltaic cells and/or compound semiconductor photovoltaic cells. In FIGS. 1 and 2, photoelectric converter 170 has silicon photovoltaic cells 100 as an example.

The photoelectric converter 170 may include ribbons 150 electrically connecting the photovoltaic cells 100, and bus ribbons 180 connecting ends of the ribbons 150. The ribbons 150 may connect the photovoltaic cells 100 in series and/or parallel. The photovoltaic cells 100 may be arranged, for example, in rows to form adjacent photovoltaic cell strings neighboring each other.

Front electrodes on light-receiving surfaces of the photovoltaic cells 100 may be connected to back electrodes on opposite surfaces of the photovoltaic cells 100. The connections may be made by ribbons 150, for example, through a tabbing process. The tabbing process may be performed, for example, by applying flux to surfaces of the photovoltaic cells 100, placing ribbons 150 on the surfaces of the photovoltaic cells 100, and subjecting the photovoltaic cells 100 to a firing process.

Alternatively, conductive films may be attached between surfaces of the photovoltaic cells 100 and ribbons 150. The photovoltaic cells 100 and ribbons 150 may be subjected to a hot pressing process to connect the photovoltaic cells 100 in series and/or parallel. The conductive films may be epoxy-resin, acryl-resin, polyimide-resin, or polycarbonate-resin films in which conductive particles such as gold, silver, nickel, or copper particles are dispersed. During the hot pressing process, the conductive particles may be externally exposed (e.g., outside the films) to electrically connect the photovoltaic cells 100 and ribbons 150. If the photovoltaic cells 100 are connected using conductive films as described above, photovoltaic cell strings having photovoltaic cells 100 arranged in rows may not be bent because of a low process temperature.

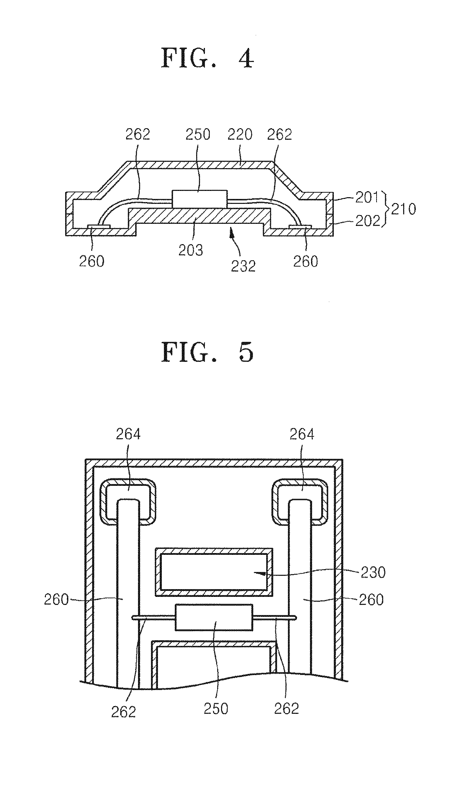

The bus ribbons 180 may alternately connect both ends of the ribbons 150. In addition, the bus ribbons 180 may be connected to a diode 250 (see, e.g., FIG. 4) through holes 264 injunction box 200, which is disposed on the second substrate 120 of the photovoltaic module 10.

The junction box 200 collects electricity generated from the photovoltaic cells 100 and allows a forward current to flow, while preventing flow of a reverse current. The junction box 200 may include the diode 250 (see, e.g., FIG. 4) for this purpose. The diode 250 may generate a large amount of heat during operation. If the heat is allowed to be transferred to the photovoltaic cells 100 (e.g., ones close to junction box 200), the temperatures of the photovoltaic cells 100 may be increased. This may cause a reduction in the efficiency of the photovoltaic cells 100.

When some of the photovoltaic cells 100 electrically connected to each other are decreased in efficiency in this way, the total efficiency of the photovoltaic module 10 is decreased. To prevent this from happening, in accordance with one embodiment, a gap is formed between the second substrate 120 and a bridge 220 (see FIG. 3) in which the diode 250 (see FIG. 4) is disposed. The gap allows for a reduction (or minimization) of heat transfer from diode to the photovoltaic cells 100 of the photovoltaic module 10. The gap may be, for example, an air gap functioning as a good thermal insulation layer Thus, a reduction in the transfer of heat generated from diode 250 (see FIG. 4) to photovoltaic cells 100 may be reduced or minimized.

The first substrate 110 may be formed of a material having a high degree of light transmittance, such as glass or a polymer material. The first substrate 110 may have sufficient rigidity to protect the photovoltaic cells 100 from impact. For example, the first substrate 110 may be formed of tempered glass. In one embodiment, the first substrate 110 may be formed of low-iron tempered glass to prevent reflection of sunlight and increase sunlight transmittance.

The second substrate 120 functions as a waterproof, insulative, and ultraviolet-proof layer to protect the back sides of the photovoltaic cells 100. The second substrate 120 may be formed, for example, by stacking polyvinyl fluoride, polyethylene terephthalate (PET), and/or polyvinyl fluoride layers.

The photovoltaic module 10 may include a first sealing film 130 between the first substrate 110 and photovoltaic cells 100, and a second sealing film 140 between the second substrate 120 and photovoltaic cells 100.

The first sealing film 130 may be on light-receiving surfaces of the photovoltaic cells 100, The second sealing film 140 may be on opposite surfaces of the photovoltaic cells 100. The first sealing film 130 and second sealing film 140 may be bonded, for example, by a lamination method, to prevent permeation of moisture and/or oxygen into the photovoltaic cells 100. The first sealing film 130 and second sealing film 140 may be formed of a material such as an ethylene vinyl acetate (EVA) copolymer resin, polyvinyl butyral, an EVA partial oxide, a silicon resin, an ester-containing resin, and/or an olefin-containing resin.

FIG. 3 illustrates an example of junction box 200 of photovoltaic module 10 illustrated in FIG. 1. FIG. 4 illustrates a view taken along section line I-I of FIG. 3. FIG. 5 illustrates a plan view of a portion of junction box 200 in FIG. 3. Referring to FIGS. 1-3 and 5, junction box 200 includes a body 210 and a diode 250 in the body 210

The body 210 includes an upper case 201 coupled to a lower case 202. The body 210 may be formed, for example, of an insulative polymer material. In addition, the upper case 201 and lower case 202 may be formed in one piece, e.g., may be integrally formed. Body 210 may be formed in one piece, for example, by an insert molding method after connecting electrodes 260 to the diode 250 using lead lines 262. Then, a pair of first parts P1, a second part P2, and a bridge 220 may be formed in one piece. In addition, since electronic devices such as the diode 250 are included in the body 210, the body 210 may have a sealing structure to prevent permeation of moisture and oxygen. In other embodiments, body 210 may be formed of multiple pieces coupled together. Also, in one embodiment, body 210 may have a ⊂ -shape. For example, second part P2 may connect ends of first parts P1 that are parallel to one another. In addition, bridge 220 may connect the pair of first parts P1 by crossing therebetween.

The diode 250 is disposed in the bridge 220. Electrodes 260 are connected to the diode 250 and are disposed in the pair of first parts P1, respectively. The electrodes 260 may connect to the diode 250 through lead lines 262. In addition, ends of the electrodes 260 may be electrically connected to bus ribbons 180, inserted into the junction box 200 through the holes 264. Other ends of electrodes 260 may be electrically connected to an external electronic device, to provide electricity generated by the photovoltaic cells 100 to an external electronic device. To this end, connection parts 240 may be formed on the other ends of the pair of first parts P1 for electric connection with the external electronic device.

When junction box 200 is attached or mounted to the second substrate 120, an adhesive layer may only be formed on the bottom surfaces of the pair of first parts P1 and the bottom surface of the second part P2. In other words, a bottom surface 232 of the bridge 220 may be higher than bottom surfaces of first parts P1 and the bottom surface of the second part P2.

Therefore, as shown in FIG. 1, when junction box 200 is attached to the second substrate 120, a gap is formed between the second substrate 120 and bridge 220. The gap may be an air gap functioning as a thermal insulation layer. In other embodiments, the gap may be filled with a material e.g., an insulation or heat transfer (e.g., heat sink) material. Either way, heat transfer from the diode 250 to the photovoltaic cells 100 may be reduced or minimized.

The bridge 220 includes a support part 203 to support diode 250. The support part 203 may be thicker than the other region of the body 210. Because the body 210 may be formed of a polymer material, when the support part 203 is thick, heat transfer from the diode 250 to the photovoltaic cells 100 may be blocked more effectively.

As described above, in one embodiment, the bottom surface 232 of the bridge 220 is higher than bottom surfaces of the pair of first parts P1 and the second part P2. Also, the support part 203 may be relatively thick. Therefore, bridge 220 may protrude outwardly more than first parts P1 and second part P2, to ensure a space in which the diode 250 may be disposed. When the bridge 220 protrudes outwardly in this manner, the area of the bridge 220 exposed to air is increased. Thus, the bridge 220 may be cooled more efficiently to prevent thermal deterioration of the diode 250.

In one embodiment, bridge 220 may be formed in the same direction as the second part P2 and may spaced apart from the second part P2. Therefore, an opening 230 may be formed between the bridge 220 and the second part P2.

The opening 230 is formed through body 210. After junction box 200 is attached to the second substrate 120, the second substrate 120 is exposed through opening 230. In addition, the opening 230 may be connected to the gap between the second substrate 120 and bridge 220.

Therefore, the top surface, a pair of lateral surfaces, and the bottom surface 232 of the bridge 220 may be exposed to air. As a result, air may circulate around the bridge 220 and bridge 220 may be cooled more efficiently to prevent thermal deterioration of the diode 250.

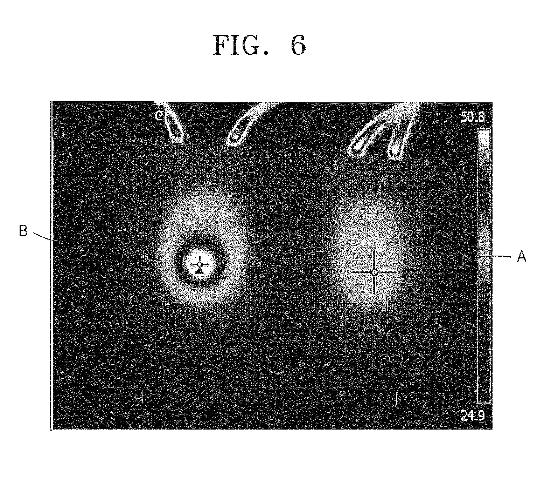

FIG. 6 illustrates an example of a measured temperature distribution of second substrate 120 in FIG. 1. This figure compares a temperature distribution for a side of the second substrate 120 measured after attaching the junction box 200 and another type of junction box attached to the second substrate 120. More specifically, portion A in FIG. 6 corresponds to a surface of second substrate 120 attached to the junction box 200 including the gap of the present embodiment, and portion B corresponds to a surface of the second substrate 120 attached to the other type of junction box. Unlike the present embodiment, the entire bottom surface of the other type of junction box contacts the second substrate 120. The second substrate 120 is formed by stacking polyvinyl fluoride, PET, and polyvinyl fluoride layers.

Referring to FIG. 6, the temperature of portion A is about 41.5°C and the temperature of portion B is about 53.6°C. That is, junction box 200 of the present embodiment transfers a relatively smaller amount of heat to the second substrate 120. Therefore, because heat transfer from junction box 200 to the photovoltaic cells 100 is reduced, the efficiency of the photovoltaic cells 100 may not be decreased or otherwise adversely affected.

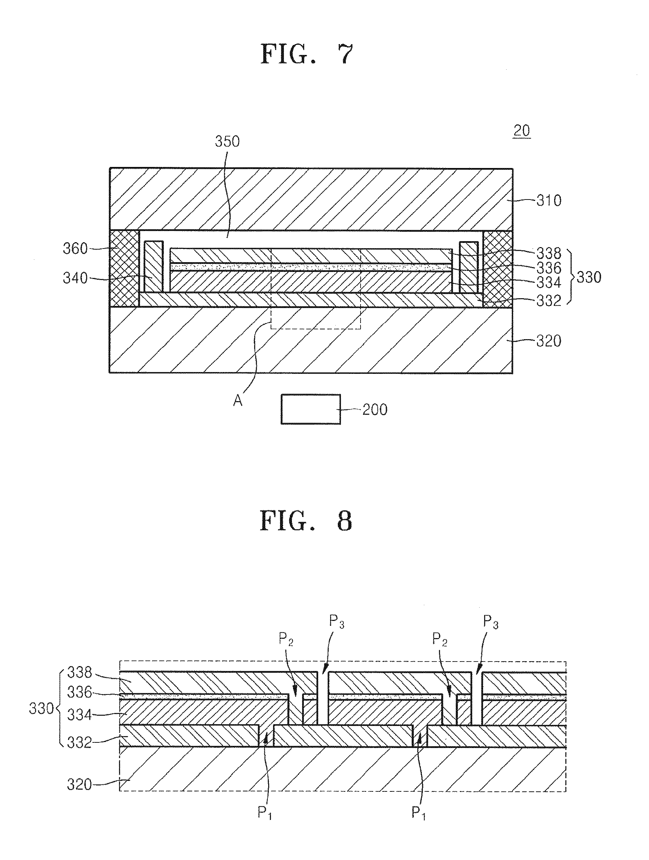

The bridge 220 containing diode 250 protrudes outwardly, and thus all of the outer surfaces of the bridge 220 are exposed to air. Therefore, the diode 250 may be efficiently cooled, and thus thermal deterioration of the diode 250 may be prevented. FIG. 7 illustrates another embodiment of a photovoltaic module 20, and FIG. 8 illustrates portion A in FIG. 7. Referring to FIGS. 7 and 8, the photovoltaic module 20 includes a photoelectric converter 330 between first and second substrates 310 and 320 that face each other. The photovoltaic module 20 also includes a junction box 200 attached to the second substrate 320 and electrically connected to the photoelectric converter 330.

The first substrate 310 may be formed of glass transmitting sunlight. The second substrate 320 may be formed of a material such as glass, stainless steel, or a polymer.

The photoelectric converter 330 may include thin-film photovoltaic cells. In one embodiment, the photoelectric converter 330 may include a back electrode layer 332, a light absorbing layer 334, a buffer layer 336, and a light transmitting electrode layer 338 sequentially stacked on the second substrate 320.

The back electrode layer 332 may collect charge generated by the photoelectric effect. The back electrode layer 332 may also reflect light transmitted through the light absorbing layer 334, so that the light may be re-absorbed by the light absorbing layer 334. The back electrode layer 332 may be formed of a metallic material having high conductivity and reflectance such as molybdenum (Mo), aluminum (Al), or copper (Cu). Particularly, the back electrode layer 332 may include molybdenum (Mo) for making ohmic contact with the light absorbing layer 334 and improving high-temperature stability in a selenium (Se) atmosphere. The back electrode layer 332 may have a multilayer structure for improving bonding with the second substrate 320 and resistance characteristics thereof. In one embodiment, the back electrode layer 332 may include a plurality of regularly-spaced parts defined by a first pattern P1.

For example, the light absorbing layer 334 may be formed of a copper-indium-selenide (CIS) compound including copper (Cu), indium (In), and selenium (Se), to form a p-type semiconductor layer absorbing incident sunlight. Alternatively, the light absorbing layer 334 may be formed of a copper-indium-gallium-selenide (Cu(In, Ga)Se2, CIGS) compound including copper (Cu), indium (In), gallium (Ga), and/or selenium (Se). The buffer layer 336 lowers the band gap difference between the light absorbing layer 334 and light transmitting electrode layer 338, and reduces recombination of electrons and holes that may occur in an interface between the light absorbing layer 334 and light transmitting electrode layer 338. The buffer layer 336 may be formed of a material such as CdS, ZnS, In2S3, or ZnxMg(1-x).

The light absorbing layer 334 and buffer layer 336 may be divided into a plurality of parts by a second pattern P2. The second pattern P2 may not be aligned with the first pattern P1. The top surface of the back electrode layer 332 may exposed through the second pattern P2.

The light transmitting electrode layer 338 makes P-N contact with the light absorbing layer 334. The light transmitting electrode layer 338 may be formed of a conductive material transmitting light such as ZnO:B, ZnO:Al, ZnO:Ga, indium Tin Oxide (ITO), or indium zinc oxide (IZO). Therefore, light transmitting electrode layer 338 may transmit incident light and collect charge formed by the photoelectric effect at the same time.

The light transmitting electrode layer 338 may also be formed in the second pattern P2, to contact back electrode layer 332 exposed through the second pattern P2 and to electrically connect parts of the light absorbing layer 334 divided by the second pattern P2. In addition, the light transmitting electrode layer 338 may be divided into a plurality of parts by a third pattern P3, which may not be aligned with first and second patterns P1 and P2. The third pattern P3 may extend to the top surface of the back electrode layer 332 to form a plurality of photoelectric conversion units connected in series.

The photoelectric converter 330 may further include a pair of electrodes 340 to collect charge formed by the photoelectric effect. The pair of electrodes 340 are attached to exposed ends of the back electrode layer 332 and electrically connected to junction box 200 on the second substrate 320. The junction box 200 may gave the same structure as described with reference to FIGS. 1 to 6.

The photovoltaic module 20 may include a sealing layer 350 between the first substrate 310 and second substrate 320, and a sealing part 360 at edges between the first substrate 310 and second substrate 320.

The sealing layer 350 may be formed of a material such as an EVA copolymer resin, polyvinyl butyral, an EVA partial oxide, a silicon resin, an ester-containing resin, and/or an olefin-containing resin. The sealing layer 350 seals the photoelectric converter 330 to prevent permeation of moisture and oxygen into the photoelectric converter 330. The sealing part 360 may bond the first substrate 310 and second substrate 320 and prevents permeation of moisture and oxygen into the photovoltaic module 20. The sealing part 360 may be formed, for example, of a thermosetting resin or photo-setting resin.

In accordance with one or more of the aforementioned embodiments, heat transfer from the junction box to the photoelectric converter is reduced or minimized. As a result, deterioration in the efficiency of the photovoltaic module may be prevented. In addition, the cooling efficiency of the diode may be improved. As a result, thermal deterioration of the diode may be prevented.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A photovoltaic module, comprising:
first and second substrates;
a photoelectric converter between the first and second substrates; and
a junction box mounted to the second substrate, the junction box including a diode electrically connected to the photoelectric converter, wherein the junction box comprises:
a pair of first mounting parts arranged to support the junction box on the second substrate; and
a bridge arranged between the first mounting parts, the diode being mounted in the bridge;
wherein the lower surface of the bridge closest to the second substrate is spaced apart from the second substrate.

2. The photovoltaic module according to claim 1, wherein the junction box further comprises a second mounting part connecting the ends of the first mounting parts,
wherein the second part is spaced from the bridge to form an opening.

3. The photovoltaic module as claimed in claim 2, wherein the first and second mounting parts are mounted to the second substrate by an adhesive layer.

4. The photovoltaic module as claimed in claim 2 or 3, wherein the gap between the bridge and the second substrate is fluidly connected to the opening.

5. The photovoltaic module as claimed in any one of the preceding claims, wherein the gap between the bridge and the second substrate is filled with a material arranged to insulate the second substrate from the diode or to transfer heat away from the second substrate.

6. The photovoltaic module as claimed in any one of the preceding claims, wherein the bridge protrudes above the top surfaces of the first mounting parts.

7. The photovoltaic module as claimed in any one of the preceding claims, wherein the first mounting parts include respective electrodes connected to the diode.

8. The photovoltaic module as claimed in claim 7, wherein the photoelectric converter includes:
a plurality of photovoltaic cells; and
a ribbon connecting the plurality of photovoltaic cells,
wherein ends of the electrodes are electrically connected to the ribbon.

9. The photovoltaic module as claimed in claim 7 or 8, further comprising connection parts on other ends of respective ones of the first mounting parts for connection to an external electronic device.

10. The photovoltaic module as claimed in any one of the preceding claims when dependent on claim 2, wherein the first mounting parts, second mounting part and bridge are integrally formed.

11. The photovoltaic module as claimed in any one of the preceding claims, wherein:
the bridge includes a support on which the diode is placed, and
the support is thicker than the other regions of the bridge.

12. The photovoltaic module as claimed in any one of the preceding claims, wherein:
the photoelectric converter includes a thin-film photovoltaic cell, and
the thin-film photovoltaic cell includes a back electrode layer, a light absorbing layer, a buffer layer, and a light transmitting electrode layer sequentially stacked on the second substrate.

13. A junction box for mounting to a substrate of a photovoltaic module, the junction box including a diode electrically connected to the photoelectric converter, wherein the junction box comprises:
a pair of first mounting parts arranged to support the junction box on the substrate; and
a bridge arranged between the first mounting parts, the diode being mounted in the bridge;
wherein the lower surface of the bridge closest to the substrate is spaced apart from the substrate when the first mounting parts are mounted to the substrate.

14. The junction box of claim 13, further comprising a second mounting part connecting the first mounting parts at an end distal from the bridge.

15. The junction box of claim 13 or 14, wherein the first mounting parts are parallel to one another.
